# EUROPEAN PATENT APPLICATION

(11) **EP 2 341 556 A2**
(43) Date of publication of application: **06.07.2011**
(21) Application number: 10016163.7
(22) Date of filing: 29.12.2010
(51) Int. Cl.: H01L 31/20, H01L 31/0376

(54) **Method for manufacturing thin film solar cell and thin film solar cell**

(30) Priority: 31.12.2009 TW 98146195
(71) Applicant: Auria Solar Co., Ltd., Tainan 74146 (TW)
(72) Inventor: Tsai, Chin-Yao, Tainan 74146 (TW)
(74) Representative: Brandenburger, Karin

(57) **Abstract**

A method for manufacturing a thin-film solar cell including the follow processes is provided. First, a substrate is provided Then, a first conductive layer is formed on the substrate. Afterward, a first photovoltaic layer is formed on the first conductive layer. Then, the first photovoltaic layer is processed by a stabilized process, so as to reduce the light induced degradation as the first photovoltaic layer is illuminated. The material of the first photovoltaic layer is an amorphous semiconductor material. Later, a second photovoltaic layer is formed on the first photovoltaic layer, Then, a second conductive layer is formed on the second photovoltaic layer. A thin-film solar cell is also provided.

## Description

This application claims the benefit to Taiwan Patent Application No. 098146195 filed on December 31, 2009, which is hereby incorporated by reference in its entirety.

### CROSS-REFERENCES TO RELATED APPLICATIONS

Not applicable.

### BACKGROUND OF THE INVENTION

### Field of the Invention

The present invention relates to a solar cell and a manufacturing method thereof, and more particularly, to a thin-film solar cell and a manufacturing method thereof,

### Descriptions of the Related Art

Currently in the solar cell market, solar cells made of monocrystalline silicon or polycrystalline silicon account for more than 90%. However, such solar cells require use of silicon wafers of about 150 microns (µm) to 350µm in thickness as a material, which leads to a high cost of the solar cells. Furthermore, the solar cells adopt silicon ingots of high quality as a raw material, and with significant increase in usage of the silicon ingots in recent years, the silicon ingots have become in short supply increasingly. Accordingly, thin-film solar cells featuring a low cost, capability of being produced in large area and a simplified manufacturing process have become a new trend of development.

Generally speaking, a conventional thin-film solar cell is typically formed by stacking an electrode layer, a photovoltaic layer and an electrode layer in sequence completely on a substrate. In the process of stacking these layers, a laser scribing process is performed to pattern these layers, so as to manufacture a plurality of sub-cells in tandem with each other. When a light ray from the outside is irradiated onto the thin-film solar cell, the photovoltaic layer of each sub-cell is adapted to generate electron-hole pairs in response to the light ray. Then, under action of a built-in electric field created at the PN or PIN junction, the electrons and holes migrate towards two layers respectively to result in an electric energy storage status. Then if a load circuit or an electronic device is externally connected across the solar cell, the electric energy can be supplied to drive the load circuit or the electronic device.

However, if the photovoltaic layer is made of a photovoltaic material like amorphous silicon, light induced degradation tends to occur after the solar cell is exposed to light irradiation for an extended period of time. This degrades the photoelectric conversion efficiency of the thin-film solar cell. Therefore, for conventional thin-film solar cells, there is still great room for improvement in the photoelectric conversion efficiency thereof. In other words, it is highly desirable in the art to improve the photoelectric conversion efficiency and electrical performance of the conventional thin-film solar cells so as to enhance the competitiveness of the solar cell products in the market.

### SUMMARY OF THE INVENTION

In view of this, the present invention provides a method for manufacturing a thin-film solar cell, which can effectively improve the photoelectric conversion efficiency of the thin-film solar cell.

Also, the present invention provides a thin-film solar cell with favorable electrical performance.

The method for manufacturing a thin-film solar cell of the present invention comprises the following steps of: providing a substrate; forming a first conductive layer on the substrate; forming a first photovoltaic layer on the first conductive layer; performing a stabilized process on the first photovoltaic layer, so as to reduce light induced degradation (LID) that occurs when the first photovoltaic layer is exposed to light irradiation, wherein the first photovoltaic layer is made of an amorphous semiconductor material; forming a second photovoltaic layer on the first photovoltaic layer; and forming a second conductive layer on the second photovoltaic layer.

The thin-film solar cell of the present invention comprises a substrate, a first conductive layer, a first photovoltaic layer, a second photovoltaic layer and a second conductive layer. The first conductive layer is disposed on the substrate. The first photovoltaic layer is disposed on the first conductive layer, wherein the first photovoltaic layer is processed through a stabilized process, and the first photovoltaic layer is made of an amorphous semiconductor material. The second photovoltaic layer is disposed on the first photovoltaic layer. The second conductive layer is disposed on the second photovoltaic layer.

In an embodiment of the present invention, the stabilized process comprises a light irradiation process or a thermal process. In an embodiment of the present invention, a light ray used in the light irradiating process is visible light, natural light, simulated solar light or a combination thereof. In an embodiment of the present invention, the thermal process comprises a high-temperature thermal annealing process or a high-temperature baking process. In an embodiment of the present invention, the thermal process is performed at a temperature of substantially higher than or equal to 200°C.

In an embodiment of the present invention, the method for manufacturing a thin-film solar cell further comprises the following steps of: patterning the first conductive layer to expose the substrate; patterning the first photovoltaic layer and the second photovoltaic layer to simultaneously expose the first conductive layer; and patterning the second conductive layer, the first photovoltaic layer and the second photovoltaic layer to simultaneously expose the substrate, In an embodiment of the present invention, the first conductive layer, the first photovoltaic layer, the second photovoltaic layer and the second conductive layer are patterned through a laser process.

In an embodiment of the present invention, the first photovoltaic layer and the second photovoltaic layer are formed through a radio frequency plasma enhanced chemical vapor deposition (RF PECVD) process, a very high frequency plasma enhanced chemical vapor deposition (VHF PECVD) process or a microwave plasma enhanced chemical vapor deposition (MW PECVD) process.

In an embodiment of the present invention, the first photovoltaic layer is made of an amorphous silicon material, and the second photovoltaic layer is made of a microcrystalline silicon material, In another embodiment of the present invention, the first photovoltaic layer and the second photovoltaic layer is each made of a group IV element thin film, a group III-V compound semiconductor thin film, a group II-VI compound semiconductor thin film, an organic compound semiconductor thin film, or a combination thereof.

In an embodiment of the present invention, the first conductive layer is made of a transparent conductive layer while the second conductive layer is made of at least one of a reflective layer and a transparent conductive layer, or the second conductive layer is made of a transparent conductive layer while the first conductive layer is made of at least one of a reflective layer and a transparent conductive layer.

According to the above descriptions, once manufacture of the first photovoltaic layer is completed, the method for manufacturing a thin-film solar cell of the present invention performs a stabilized process on the first photovoltaic layer so that internal defects or weak bonds within the first photovoltaic layer can show up in advance. Thereby, during operation of the thin-film solar cell thus manufactured, the first photovoltaic layer will be less liable to light induced degradation (LID) and, consequently, the thin-film solar cell will have a better power supplying quality and an improved photoelectric conversion efficiency. Furthermore, the present invention also provides a thin-film solar cell that has been subjected to a stabilized process.

The detailed technology and preferred embodiments implemented for the subject invention are described in the following paragraphs accompanying the appended drawings for people skilled in this field to well appreciate the features of the claimed invention.

### BRIEF DESCRIPTION OF THE DRAWINGS

**FIGs. 1A** to 1I illustrate, in form of partial cross-sectional views, a process for manufacturing a thin-filin solar cell according to an embodiment of the present invention; and
**FIG 2** is a cross-sectional view of a thin-film solar cell according to an embodiment of the present invention.

### DESCRIPTION OF THE PREFERRED EMBODIMENT

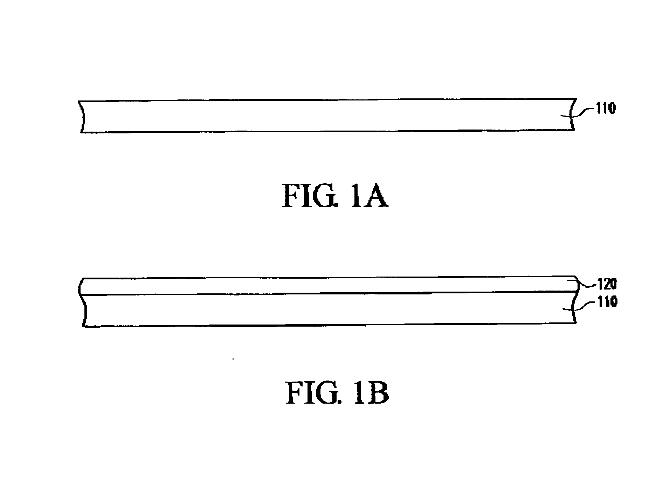

**FIGs. 1A** to **1I** illustrate, in form of partial cross-sectional views, a process for manufacturing a thin-film solar cell according to an embodiment of the present invention. Firstly, referring to **FIG. 1A**, a substrate **110** is provided. In this embodiment, the substrate **110** can be a transparent substrate, e.g., a glass substrate.

Then, a first conductive layer is formed on the substrate **110**, as shown in **FIG. 1B**. In this embodiment, the first conductive layer **120** is formed completely on the substrate **110** through, for example, a sputtering process, a metal organic chemical vapor deposition (MOCVD) process or an evaporation process.

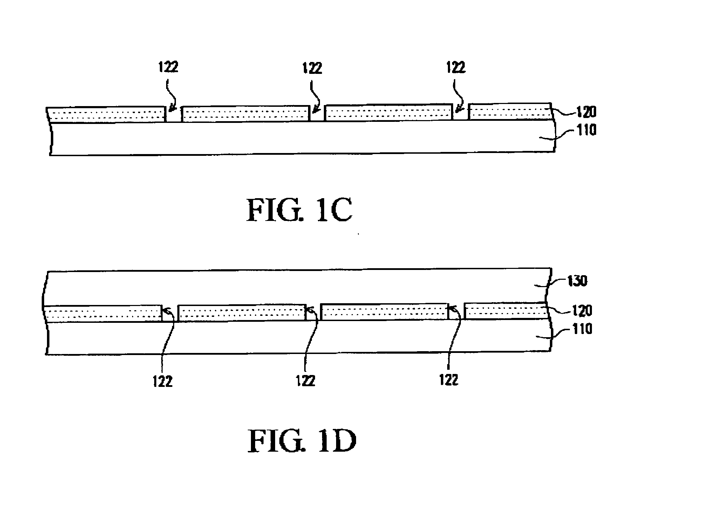

Next, the first conductive layer **120** is patterned to form a plurality of first openings **122** exposing the substrate, as shown in **FIG. 1C**. In this embodiment, the first conductive layer **120** can be patterned through a laser process; however, in other embodiments, the first conductive layer **120** can also be patterned through other appropriate processes, e.g., a semiconductor lithographic etching process. Generally speaking, the first conductive layer **120** usually serves as front contacts of a plurality tandem sub-cells to be subsequently formed. Additionally, the first conductive layer 120 can be a transparent conductive layer, which can be made of at least one of indium tin oxide (ITO), indium zinc oxide (IZO), indium tin zinc oxide (ITZO), zinc oxide, tin oxide, aluminum tin oxide (ATO), aluminum zinc oxide (AZO), cadmium indium oxide (CIO), cadmium zinc oxide (CZO), gallium zinc oxide (GZO) and tin oxyfluoride, or a combination thereof.

Afterwards, a first photovoltaic layer **130** is formed on the first conductive layer, as shown in **FIG 1D****.** In this embodiment the first photovoltaic layer **130** can be formed completely on the first conductive layer **120** through, for example, a radio frequency plasma enhanced chemical vapor deposition (RF PECVD) process, a very high frequency plasma enhanced chemical vapor deposition (VHF PECVD) process or a microwave plasma enhanced chemical vapor deposition (MW PECVD) process.

In this embodiment, the first photovoltaic layer **130** is made of, for example, an amorphous semiconductor material such as amorphous silicon. In other embodiments, the first photovoltaic layer **130** can also be made of another kind of group IV element thin film, a group III-V compound semiconductor thin film, a group II-VI compound semiconductor thin film, an organic compound semiconductor thin film or a combination thereof in an amorphous phase. Specifically, the group IV element thin film comprises, for example, at least one of a carbon element thin film, a silicon element thin film, a germanium element thin film, a silicon carbide thin film and a germanium silicide thin film, or a combination thereof in an amorphous phase. Additionally, the group III-V compound semiconductor thin film comprises, for example, GaAs, InGaP or a combination thereof in an amorphous phase. The group II-VI compound semiconductor film comprises, for example, copper indium selenium (CIS), copper indium gallium selenium (CIGS), cadmium telluride (CdTe) or a combination thereof in an amorphous phase. The organic compound semiconductor thin film can be a structure comprising a mixture of poly(3-hexylthiophene) (P3HT) and carbon nanospheres (PCBM).

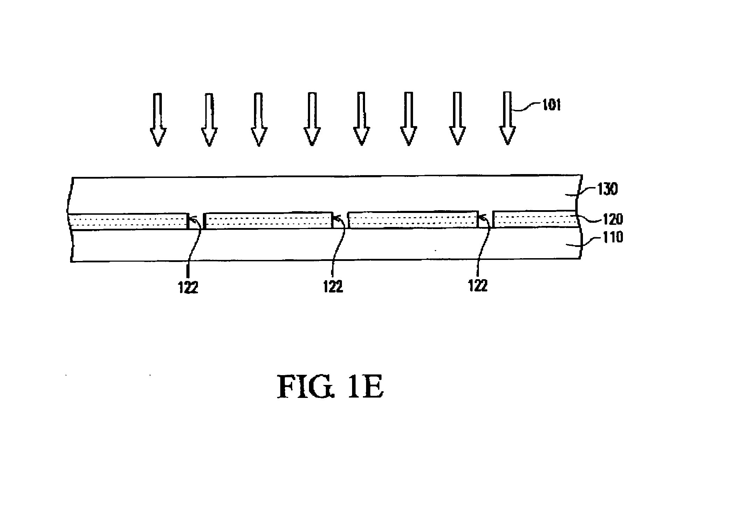

Subsequently, a stabilized process **101** is performed on the first photovoltaic layer **130** to reduce the light induced degradation of the first photovoltaic layer **130** when exposed to light irradiation, as shown in **FIG. 1E****.** In this embodiment, the stabilized process **101** is, for example, a light irradiation process or a thermal process. Specifically, because the first photovoltaic layer **130** is made of an amorphous semiconductor material (e.g., amorphous silicon), it is likely that there are many internal defects and weak bonds between silicon atoms therein. In this case, after being irradiated by light for an extended period of time, the first photovoltaic layer **130** will suffer from the light induced degradation (LID). In other words, for a thin-film solar cell whose first photovoltaic layer **130** is not processed through the stabilized process **101,** the light induced degradation will occur during operation of the thin-film solar cell to cause poor electric performance of the thin-film solar cell, e.g., instable power supplying conditions, continuous attenuation of the power supply level or degradation in the photoelectric conversion efficiency.

Therefore, in the manufacturing process of the thin-film solar cell of this embodiment, the stabilized process **101** is firstly performed on the first photovoltaic layer **130** so that the internal defects and weak bonds between silicon atoms in the first photovoltaic layer **130** can show up in advance; i.e., the light induced degradation can take place in advance. Then, once manufacture of the thin-film solar cell is completed, the first photovoltaic layer 130 will be less liable to the light induced degradation. Thus, the thin-film solar cell can supply a photocurrent more stably to present an improved electrical performance (e.g., higher power supplying stability or improved photoelectric conversion efficiency).

Additionally, the stabilized process 101 of this embodiment at least comprises the following two ways of implementation. Firstly, if a light irradiation process is used to perform the stabilized process **101,** the light ray used in the light irradiation process can be visible light. Simulated solar light or natural light such as sunlight. Additionally, if it is desired to accelerate the stabilized process, an intensity of the light ray can be increased. Secondly, if a thermal process is used to perform the stabilized process 101, then at least a high-temperature thermal annealing process or a high-temperature baking process can be used. The thermal process is performed at a temperature of substantially higher than or equal to 200°C for, for example, I to 2 hours. What described above is only for purpose of illustration, and the specific stabilized process to be chosen and related process conditions depend on requirements of the users but are not limited to what described above.

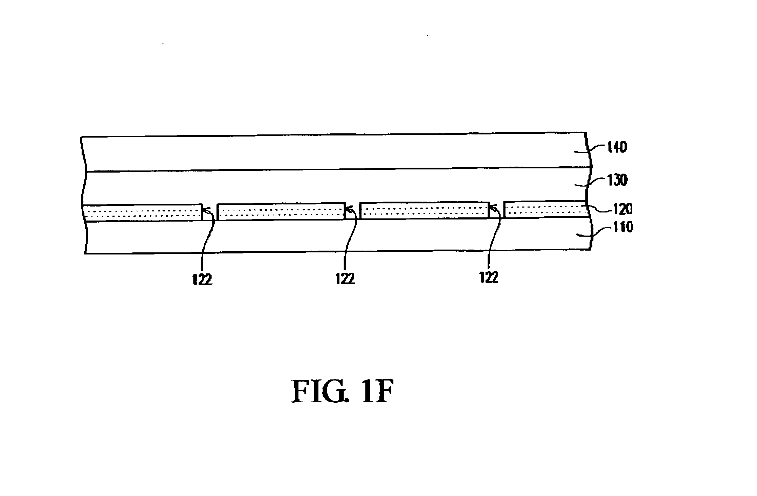

Then, a second photovoltaic layer **140** is formed on the first photovoltaic layer **130,** as shown in **FIG 1F****.** In this embodiment, the second photovoltaic layer **140** is formed, for example, in the same way as the first photovoltaic layer 130, so no further description will be made thereon herein. Additionally, the second photovoltaic layer **140** is made of a polycrystalline or microcrystalline semiconductor material.

In this embodiment, as an example, the second photovoltaic layer **140** is made of microcrystalline silicon; however, in other embodiments, the second photovoltaic layer **140** can also be made of other group IV element thin films, group III-V compound semiconductor thin films, group II-VI compound semiconductor thin films, organic compound semiconductor thin films or a combination thereof in a polycrystalline or microcrystalline phase. Specifically, the group IV element thin films comprise, for example, at least one of a carbon element thin film, a silicon element thin film, a germanium element thin film, a silicon carbide thin film and a germanium silicide thin film or a combination thereof in a polycrystalline or microcrystalline phase. The group III-V compound semiconductor thin films comprise, for example, gallium arsenide (GaAs), indium gallium phosphide (InGaP) or a combination thereof in a polycrystalline or microcrystalline phase. The group II-VI compound semiconductor thin films comprise, for example, copper indium selenium (CIS), copper gallium selenium (CIGS), cadmium telluride (CdTe) or a combination thereof in a polycrystalline or microcrystalline phase. The organic compound semiconductor thin films can be a structure comprising a mixture of paly(3-hexylthiophene) (P3HT) and carbon nanospheres (PCBM).

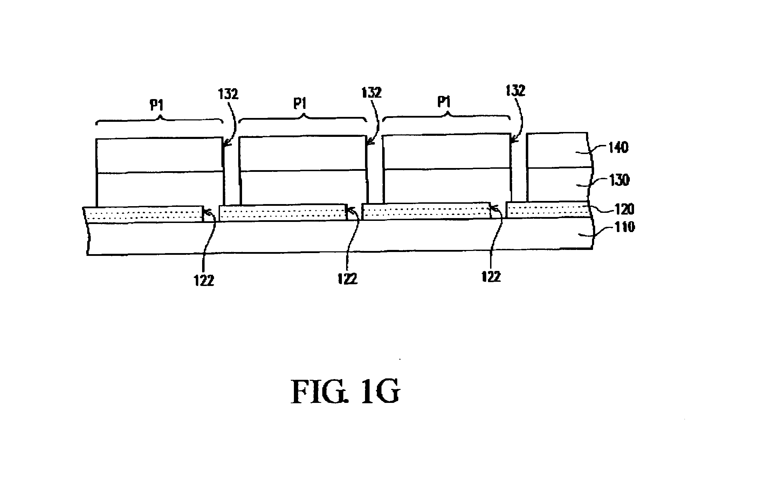

Thereafter, the first photovoltaic layer **130** and the second photovoltaic layer **140** are patterned to simultaneously form a plurality of second openings **132** exposing the first conductive layer **120,** as shown in **FIG 1G****.** In this embodiment, the first photovoltaic layer **130** and the second photovoltaic layer **140** can be patterned through a laser process; in other embodiments, the first photovoltaic layer **130** and the second photovoltaic layer **140** can also be patterned through other appropriate processes, e.g., a semiconductor lithographic etching process, Generally, after the first photovoltaic layer **130** and the second photovoltaic layer **140** are patterned, photoelectric conversion regions P1 of a plurality of tandem sub-cells can be formed.

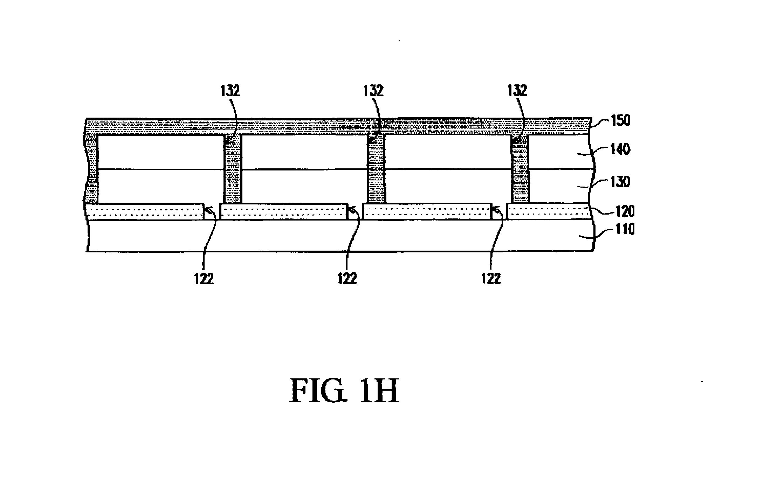

Then, a second conductive layer **150** is formed on the second photovoltaic layer **140,** as shown in **FIG. 1H****.** In this embodiment, the second conductive layer **150** is electrically connected with the first conductive layer **120** through the second openings **132.** The second conductive layer **150** is formed, for example, in the same way as the first conductive layer **120,** so no further description will be made thereon. Generally, the second conductive layer is usually used as back contacts of the plurality of sub-cells. Hence, in an embodiment, apart from using the transparent conductive material described with reference to the first conductive layer **120,** the second conductive layer **150** can further comprise a reflective layer (not shown) disposed between the transparent conductive layer and the second photovoltaic layer **140.** The reflective layer can be made of a metal with desirable reflectivity such as silver (Ag) or aluminum (A1).

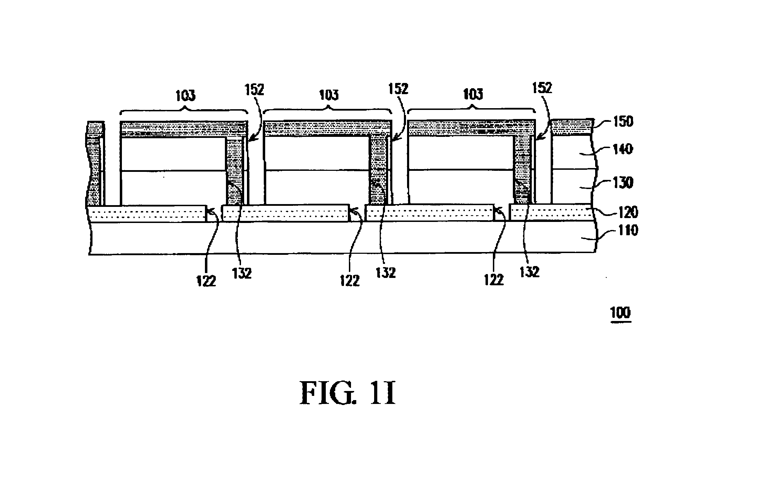

Afterwards, the second conductive layer **150,** the second photovoltaic layer **140** and the first photovoltaic layer **130** are patterned to simultaneously form a plurality of third openings **152** exposing the first conductive layer **120,** as shown in **FIG 1I****.** In this embodiment, the second conductive layer **150,** the second photovoltaic layer **140** and the first photovoltaic layer **130** are patterned through, for example, a laser process. In other embodiments, other appropriate processes such as a semiconductor lithographic etching process can be used. Generally, subsequent to the step shown in FIG 1I, a plurality of sub-cells can be formed. The second conductive layer **150** serves as the back contact of each of the sub-cells **103**, and is electrically connected with the first conductive layer **120** of an adjacent sub-cell **103** through the second openings **132**. In this way, the tandem electrical connection described above can be formed. Thus, the method for manufacturing the thin-film solar cell **100** is substantially completed.

It is worth noting that, in the above description, the thin-film solar cell **100** having a plurality of tandem sub-cells **103** is described as an example; however, in other embodiments, instead of using the patterning process (i.e., instead of a structure having openings), the thin-film solar cell can also be manufactured by sequentially forming the first conductive layer, the first photovoltaic layer, the second photovoltaic layer and the second conductive layer, in which case the stabilized process is performed on the first photovoltaic layer after formation of the first photovoltaic layer. That is, the manufacturing process of the present invention can also form a thin-film solar cell having only a single sub-cell structure.

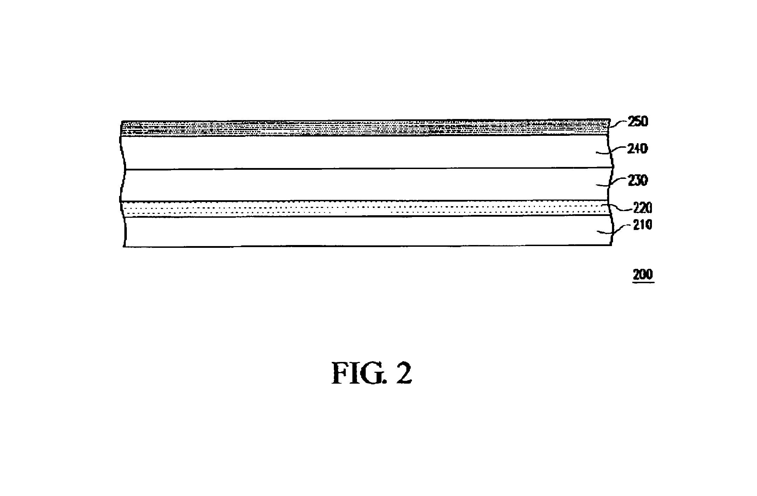

As can be known from the above description, a structure of a thin-film solar cell **200** as shown in **FIG. 2** can also be proposed. **FIG. 2** is a cross-sectional view of a thin-film solar cell according to an embodiment of the present invention. Referring to **FIG 2**, the thin-film solar cell **200** comprises a substrate **210**, a first conductive layer **220**, a first photovoltaic layer **230**, a second photovoltaic layer **240** and a second conductive layer **250**. The first conductive layer **220** is disposed on the substrate **210**. The first photovoltaic layer **230** is disposed on the first conductive layer **220**. The first photovoltaic layer **230** has been processed through the stabilized process **101** described above, and is made of, for example, the aforesaid amorphous semiconductor material. The second photovoltaic layer **240** is disposed on the first photovoltaic layer **230**. The second conductive layer **250** is disposed on the second photovoltaic layer **240**.

In this embodiment, for example, the materials and characteristics of the first conductive layer **220**, the first photovoltaic layer **230**, the second photovoltaic layer **240** and the second conductive layer **250** are the same as what described above with reference to the first conductive layer **120**, the first photovoltaic layer **130**, the second photovoltaic layer **140** and the second conductive layer **150** respectively. In other words, the thin-film solar cell **200** also has the same advantages as the thin-film solar cell **100**.

According to the above descriptions, the thin-film solar cell and the manufacturing method thereof of the present invention have at least the following advantages. Firstly, upon completion of manufacture of the first photovoltaic layer, a stabilized process is performed on the first photovoltaic layer so that internal defects or weak bonds within the first photovoltaic layer can show up in advance. Thereby, during operation of the thin-film solar cell thus manufactured, the first photovoltaic layer will be less liable to light induced degradation (LID) and, consequently, the thin-film solar cell will have a desirable power supplying quality and an improved photoelectric conversion efficiency. Furthermore, the present invention also provides a thin-film solar cell that has been processed through a stabilized process.

The above disclosure is related to the detailed technical contents and inventive features thereof. People skilled in this field may proceed with a variety of modifications and replacements based on the disclosures and suggestions of the invention as described without departing from the characteristics thereof. Nevertheless, although such modifications and replacements are not fully disclosed in the above descriptions, they have substantially been covered in the following claims as appended.

## Claims

1. A method for manufacturing a thin-film solar cell, comprising:
providing a substrate;
forming a first conductive layer on the substrate
forming a first photovoltaic layer on the first conductive layer;
performing a stabilized process on the first photovoltaic layer to reduce light induced degradation (LID) that occurs when the first photovoltaic layer is exposed to light irradiation, wherein the first photovoltaic layer is made of an amorphous semiconductor material;
forming a second photovoltaic layer on the first photovoltaic layer; and
forming a second conductive layer on the second photovoltaic layer.

2. The method for manufacturing a thin-film solar cell as claimed in claim 1, wherein the stabilized process comprises a light irradiating process or a thermal process.

3. The method for manufacturing a thin-film solar cell as claimed in claim 2, wherein a light ray used in the light irradiating process is visible light, natural light, simulated solar light or a combination thereof.

4. The method for manufacturing a thin-film solar cell as claimed in claim 2, wherein the thermal process comprises a high-temperature thermal annealing process or a high-temperature baking process.

5. The method for manufacturing a thin-film solar cell as claimed in claim 2, wherein the thermal process is performed at a temperature of substantially higher than or equal to 200°C.

6. The method for manufacturing a thin-film solar cell as claimed in claim 1, further comprising:
patterning the first conductive layer to expose the substrate;
patterning the first photovoltaic layer and the second photovoltaic layer to simultaneously expose the first conductive layer, and
patterning the second conductive layer, the first photovoltaic layer and the second photovoltaic layer to simultaneously expose the substrate.

7. The method for manufacturing a thin-film solar cell as claimed in claim 6, wherein the first conductive layer, the first photovoltaic layer, the second photovoltaic layer and the second conductive layer are patterned through a laser process.

8. The method for manufacturing a thin-film solar cell as claimed in claim 1, wherein the first photovoltaic layer and the second photovoltaic layer are formed through a radio frequency plasma enhanced chemical vapor deposition (RF PECVD) process, a very high frequency plasma enhanced chemical vapor deposition (VHF PECVD) process or a microwave plasma enhanced chemical vapor deposition (MW PECVD) process.

9. The method for manufacturing a thin-film solar cell as claimed in claim 1, wherein the first photovoltaic layer is made of an amorphous silicon material, and the second photovoltaic layer is made of a microcrystalline silicon material.

10. The method for manufacturing a thin-nim solar cell as claimed in claim 1, wherein each of the first photovoltaic layer and the second photovoltaic layer is made of a group IV element thin film, a group III-V compound semiconductor thin film, a group II-VI compound semiconductor thin film, an organic compound semiconductor thin film, or a combination thereof.

11. The method for manufacturing a thin-film solar cell as claimed in claim 1, wherein the first conductive layer is made of a transparent conductive layer while the second conductive layer is made of at least one of a reflective layer and a transparent conductive layer, or the second conductive layer is made of a transparent conductive layer while the first conductive layer is made of at least one of a reflective layer and a transparent conductive layer.

12. A thin-film solar cell, comprising:
a substrate;
a first conductive layer disposed on the substrate;
a first photovoltaic layer disposed on the first conductive layer, wherein the first photovoltaic layer is processed through a stabilized process, and the first photovoltaic layer is made of an amorphous semiconductor material;
a second photovoltaic layer disposed on the first photovoltaic layer; and
a second conductive layer disposed on the second photovoltaic layer.

13. The thin-film solar cell as claimed in claim 12, wherein the stabilized process comprises a light irradiation process or a thermal process.

14. The thin-film solar cell as claimed in claim 13, wherein a light ray used in the light irradiation process is visible light, natural light, simulated solar light or a combination thereof.

15. The thin-film solar cell as claimed in claim 13, wherein the thermal process comprises a high-temperature thermal annealing process or a high-temperature baking process, and the thermal process is performed at a temperature of substantially higher than or equal to 200°C.
